# EUROPEAN PATENT APPLICATION

(11) **EP 4 300 743 A1**
(43) Date of publication of application: **03.01.2024**
(21) Application number: 23181768.5
(22) Date of filing: 27.06.2023
(51) Int. Cl.: H02H 3/20, G01R 22/06

(54) **INPUT OVERVOLTAGE PROTECTION**

(30) Priority: 29.06.2022 US 202217853049
(71) Applicant: Itron, Inc., Liberty Lake, WA 99019 (US)
(72) Inventor: LANCASTER, Andrew, 99019 Liberty Lake (US); TEWARI, Dipankar L., 99019 Liberty Lake (US)
(74) Representative: Morrall, Jonathan Ian McLachlan

(57) **Abstract**

A method, apparatus, and system for providing an input overvoltage protection are disclosed. A voltage monitor may monitor input voltage (302) to an electricity meter and output a reference voltage (322) associated with, or based at least in part on, the input voltage. A ground switch (326) may electrically connect a first ground (218) to a second ground (228) allowing current to flow from the second ground to the first ground and charge a bulk capacitor (220) up to a predetermined level when the reference voltage is less than or equal to a threshold voltage, and electrically disconnect the first ground from the second ground and prevent from charging the bulk capacitor higher than the predetermined level when the reference voltage is greater than the threshold voltage.

## Description

### TECHNICAL FIELD

The present disclosure generally relates to the field of overvoltage protection, and more specifically to methods, devices, and systems for limiting a maximum voltage present to downstream components during input overvoltage conditions.

### BACKGROUND

In an electricity meter connected to an electrical grid, a problem can arise in certain applications if there is no load on the electricity meter. For example, a ferroresonance situation can arise when an output wiring of the transformer has sufficient capacitance to cause an output of the transformer that is supplying the electricity meter to resonate, and cause abnormally high voltages to be presented at an input of the electricity meter. Unless the electricity meter is protected from this abnormally high voltage, damage to the electricity meter can occur.

To protect an electricity meter from this type of high voltage situation, some safety mechanisms include switches to disconnect a power supply of the electricity meter when the high voltage conditions occur, which powers down the electricity meter. By disconnecting the power supply and powering down the electricity meter, however, operation of the electricity meter is at least temporarily interrupted.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures indicates similar or identical items or features.
FIG. 1 illustrates an example power distribution environment in which an input overvoltage protection may be utilized.
FIG. 2 illustrates a block diagram of an example input overvoltage protection module and surrounding components.
FIG. 3 illustrates an example schematic diagram of the input overvoltage protection module.
FIG. 4 illustrates an example process for providing input overvoltage protection.
FIG. 5 illustrates an example block diagram of an electricity meter.

### DETAILED DESCRIPTION

This application describes methods, apparatus, and systems for limiting a maximum voltage present to downstream components during input overvoltage conditions. When an input overvoltage condition occurs, an input overvoltage protection effectively limits an input voltage experienced by sensitive components downstream from the input overvoltage protection by limiting a charge on a bulk capacitor by providing a different ground for the bulk capacitor, thereby allowing the sensitive components to continue to function. In some instances, the techniques described herein may be applicable in the case of an extreme input overvoltage condition (e.g., an input overvoltage condition significantly above the maximum operating voltage of the meter power supply components), though the techniques may also be applicable to mitigate smaller input overvoltage situations as well.

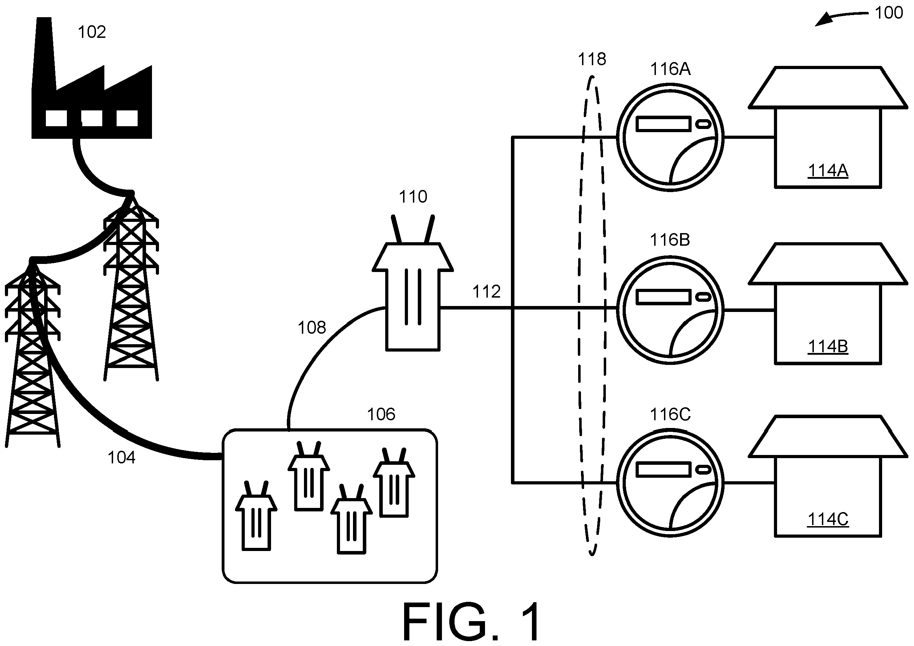

FIG. 1 illustrates an example environment 100 in which an input overvoltage protection system may be utilized. In this example, a power plant 102 generates electricity, which is carried by high voltage lines 104 to a power substation 106. The power substation 106 provides electricity via a feeder 108 to a transformer 110. The feeder 108 is a power line consisting of individual power lines 112 servicing a plurality of premises 114 connected via the transformer 110 and electricity meters 116A, 116B, and 116C providing electricity to associated premises 114A, 114B, and 114C. However, under a no-load condition, a ferroresonance situation can arise when an output wiring (not shown) of the transformer 110 has sufficient capacitance to cause the output of the transformer, that is supplying the electricity meter 116, to resonate. This ferroresonance causes abnormally high voltages (e.g., voltages up to 960 Vac or more) to be presented to the AC input 118 of the electricity meter 116. Unless the electricity meter 116 is protected from this abnormally high voltage, damages to the electricity meter 116 can occur during a ferroresonance situation.

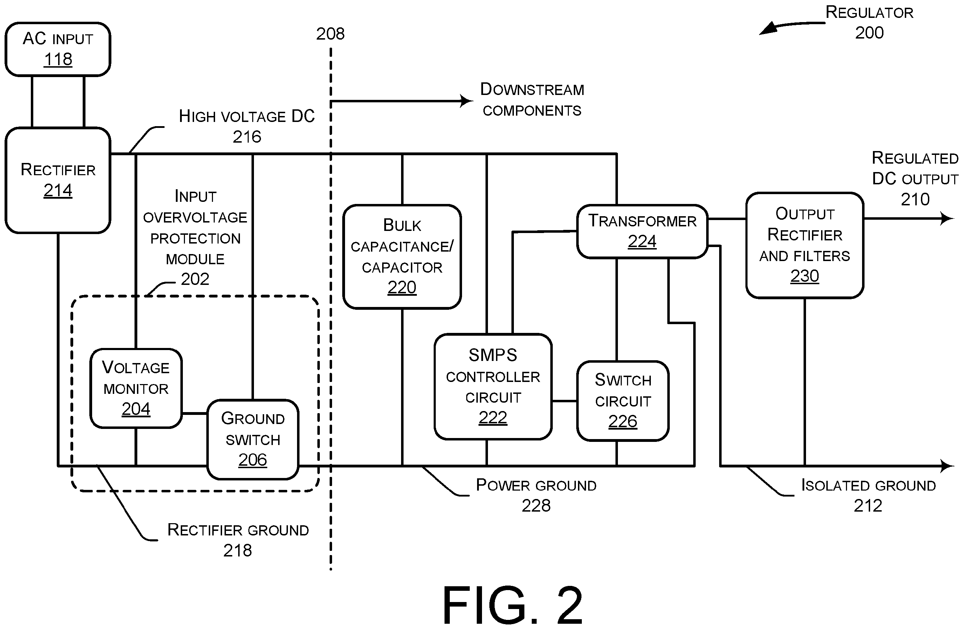

FIG. 2 illustrates a block diagram of an example regulator 200 including an input overvoltage protection module 202 and surrounding components. The input overvoltage protection module 202 may comprise a voltage monitor 204 and a ground switch 206. All or some of the components of the regulator 200 may be housed in an electricity meter, such as the electricity meter 116. Downstream components, shown to the right of a dotted line 208, are protected from abnormally high voltages present at the AC input 118 by utilizing the input overvoltage protection module 202, and a regulated DC output 210 from the regulator 200 may provide a regulated DC voltage to components of the electricity meter 116, such as a processor, metrology module, communication module, and other circuits and components of the electricity meter 116 (not shown). The regulated DC output 210 is referenced to an isolated ground 212.

As described above with reference to FIG. 1, the AC input 118 of the electricity meter 116 is connected to the power line 112 from the transformer 110, and the AC from the power line 112 is rectified by a rectifier 214, which outputs a high voltage DC 216 and provides a rectifier ground 218. The AC input 118 and/or the rectifier 214 may also include one or more filters (not shown). The high voltage DC 216 may normally be in a range of about 135 Vdc to 815 Vdc, which corresponds to an AC input voltage range of 96 Vac to 576 Vac. For an overvoltage condition, such as a ferroresonance event, the AC input voltage at the AC input 118 may reach 960 Vac, which corresponds to roughly 1350 Vdc on the High Voltage DC 216 relative to the rectifier ground 218, which may be too high for some of the downstream components, such as those of the power supply of the electricity meter 116, to tolerate. The downstream components may include a bulk capacitance or bulk capacitor 220 (which may comprise one or more individual capacitors or capacitive elements), a switch mode power supply (SMPS) controller circuit 222, a transformer 224, and a switch circuit 226, all of which are grounded to a power ground 228, or a second ground, which is an electrical ground for components of the power supply of the electricity meter 116. The downstream components also include an output rectifier and filters 230 connected to the transformer 224. The output rectifier and filters 230 provide the regulated DC output 210 and the isolated ground 212 for the processor, metrology module, communication module, and other circuits and components of the electricity meter 116.

Under normal operating conditions when there is no overvoltage or a ferroresonance condition, the ground switch 206 is biased "ON" through components that are connected to the high voltage DC 216, which allow current to flow from the power ground 228 to the rectifier ground 218. As current flows from the power ground 228 to the rectifier ground 218 through the ground switch 206, the current charges or maintains the charge on the bulk capacitor 220 during operation. The voltage monitor 204 monitors the AC input voltage at the AC input 118. For example, the voltage monitor 204 may be designed to monitor the AC input voltage and limit the high voltage DC 216 to a rated voltage for the downstream components, for example, 800 Vdc relative to the power ground 228, such that the bulk capacitor 220 and all other downstream components will not experience a voltage above 800 Vdc. When the AC input voltage begins to approach a preselected threshold level, which is a level near the maximum operating range specified for the downstream components, the ground switch 206 is turned "OFF." By turning off the ground switch 206, the power ground 228 is disconnected from the rectifier ground 218, which prevents the bulk capacitor 220 from continuing to be charged and prevents excessive and damaging voltage from being provided to the downstream components. The ground switch 206 remains off until the AC input voltage at the AC input 118 falls to a safe voltage.

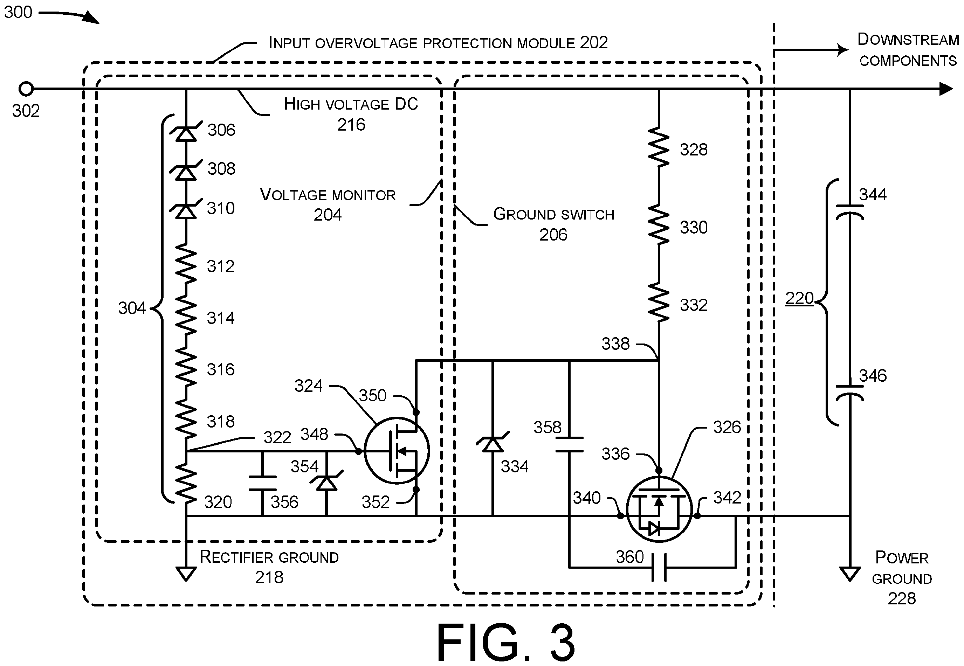

FIG. 3 illustrates an example schematic diagram 300 of the input overvoltage protection module 202, which provides lower unharmful voltage to the downstream components when an input overvoltage situation occurs, and some surrounding components. As described above with reference to FIG. 2, the input overvoltage protection module 202 comprises a voltage monitor 204 and a ground switch 206, both of which are described below.

The voltage monitor 204 comprises a voltage input 302, which is connected to the rectifier 214 and receives high voltage DC 216 from the rectifier 214. The rectifier 214 also provides the rectifier ground 218 for the voltage monitor 204. The rectifier ground 218 may also be referred to as a first ground. The voltage monitor 204 may also comprise a voltage divider 304, which is coupled to the voltage input 302 and the rectifier ground 218. The voltage divider 304 may comprise one or more Zener diodes and one or more resistors. In this example, three Zener diodes 306, 308, and 310, and five resistors 312, 314, 316, 318, and 320 are shown. The voltage divider 304 is configured to provide a reference voltage at a first point 322 of the voltage divider 304, which is shown at a junction of the resistors 318 and 320 in this example. Characteristics of the Zener diodes 306, 308, and 310 and values of the resistors 312 - 320 are selected such that these Zener diodes block voltage low enough to be safe for the downstream components on the high voltage DC 216 from the rectifier 214, but begin to conduct as the voltage on the high voltage DC 216 approaches a critical voltage that is high enough to potentially damage the downstream components. As the Zener diodes 306, 308, and 310 begin to conduct, current flows through the voltage divider 304, and the reference voltage at the first point 322 begins to increase as the voltage on the high voltage DC 216 increases.

The voltage monitor 204 also includes a switch driver, shown in this example as a first field effect transistor (FET) 324, which is designed to control a second FET 326 of the ground switch 206. The second FET 326 is normally, when there is no input overvoltage situation, biased by resistors (three resistors 328, 330, and 332 are shown in this example) and a Zener diode 334, and is in an "ON" state and connects the power ground 228 to the rectifier ground 218. That is, the Zener diode 334 limits the voltage on a gate 336 of the second FET 326 to protect it and prevents current flow through the resistors 328, 330, and 332 to ensure that a voltage at the gate 336 is greater than a gate-source threshold voltage of the FET 326 even at lower AC input voltages. When the gate 336, which is connected to a second point 338, receives a voltage greater than or equal to the gate-source threshold voltage of the second FET 326 relative to a source 340 of the second FET 326, which is connected to the rectifier ground 218, current is allowed to flow from a drain 342 of the second FET 326, which is connected to the power ground 228, to the source 340. The current flow charges and/or maintains charge on the bulk capacitor capacitance 220 during operation. The bulk capacitor 220 in this example is shown to comprise two capacitors 344 and 346 in series.

To control "on/off' state of the second FET 326, "ON/OFF" state of the first FET 324 based on the input AC input voltage is utilized. As described above, the reference voltage at the first point 322 increases as the voltage on the high voltage DC 216 increases, that is, as the AC voltage at the AC input 118 increases. A gate 348 of the first FET 324 is connected to the first point 322 and receives the reference voltage from the voltage divider 304. When the reference voltage reaches a gate-source threshold voltage of the first FET 324, the FET 324 is turned "ON" and current is allowed to flow from a drain 350 of the first FET 324 to a source 352 of the first FET 324. Because the drain 350 is connected to the second point 338 that is also connected to the gate 336 of the second FET 326, and the source 352 is connected to the rectifier ground 218, the Zener diode 334 is shunted when the first FET 324 is "ON" and the gate 336 is grounded. As the gate 336 becomes grounded, the second FET 326 is turned "OFF" and effectively disconnects the power ground 228 from the rectifier ground 218, thereby preventing the voltage between the high voltage DC 216 and the power ground 228 from further increase. By preventing the voltage from further increase, the bulk capacitor 220 is prevented from continuing to charge beyond a predetermined level, which may be set at the highest DC voltage the downstream components can safely tolerate, and the downstream components are prevented from experiencing excessive voltage. A Zener diode 354 is connected to the gate 348 to protect the gate 348.

FIG. 3 also illustrates additional components associated with input overvoltage protection module 202, such as a capacitor 356 connected to the gate 348 and the rectifier ground 218, a capacitor 358 connected to the gate 336 and the rectifier ground 218, and a capacitor 360 connected to the power ground 228 and the rectifier ground 218, which may reduce high frequency noises.

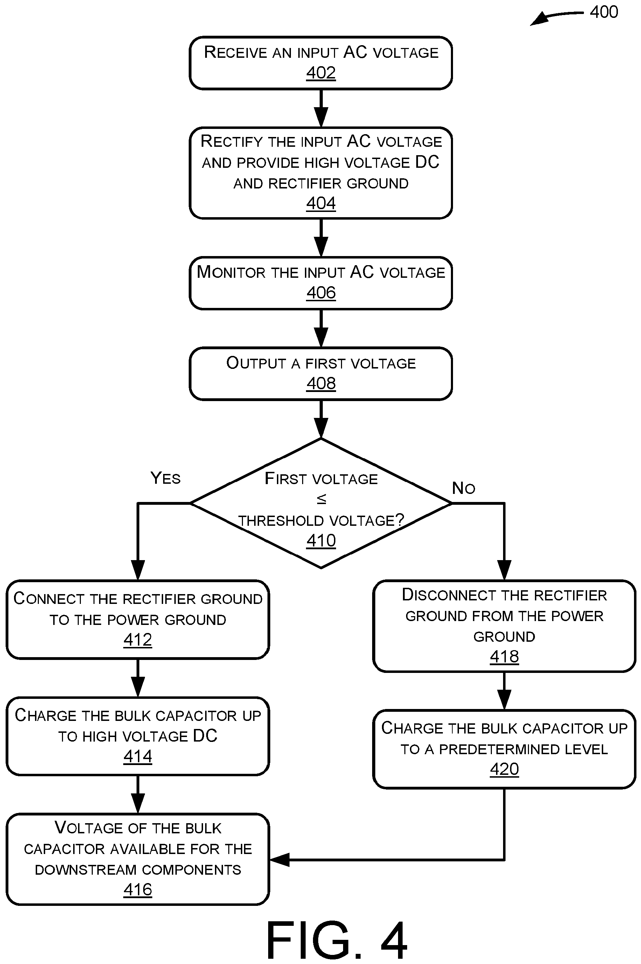

FIG. 4 illustrates an example process 400 for providing input overvoltage protection. At block 402, an electricity meter, such as the electricity meter 116 described above with reference to FIGs. 1 and 2, may receive an input AC voltage from the power line 112 at the AC input 118. At block 404, a rectifier, such as the rectifier 214, may rectify the input AC voltage and provide high voltage DC, such as the high voltage DC 216, and provide a reference electrical ground, such as the rectifier ground 218, or the first ground. At block 406, a voltage monitor of an input overvoltage protection module, such as the voltage monitor 204 of the input overvoltage protection module 202, may monitor the input AC voltage based on the high voltage DC 216 and, at block 408, output a reference voltage associated with, or based at least in part on, the input AC voltage, for example, by utilizing a voltage divider comprising one or more Zener diodes and one or more resistors as described above with reference to FIG. 3.

At block 410, whether the reference voltage is less than or equal to a threshold voltage is determined. When the reference voltage is less than or equal to the threshold voltage ("YES" branch), the rectifier ground 218 may be electrically connected to a second ground, such as the power ground 228, at block 412. As discussed above with reference to FIG. 3, connecting and disconnecting the rectifier ground 218 to and from the power ground 228 may be accomplished by controlling states of a pair of FETs such as the first FET 324 and the second FET 326. By connecting the rectifier ground 218 to the power ground 228, current is allowed to flow from the power ground 228 to the rectifier ground 218 and charges a bulk capacitor, such as the bulk capacitor 220 connected to the high voltage DC 216 and the power ground 228, up to a level of the high voltage DC 216 at block 414. The voltage of the charged capacitor is made available for the downstream components, for example, the power supply of the electricity meter 116 at block 416.

However, when the reference voltage is not less than or equal to the threshold voltage, that is, the reference voltage is higher than the threshold voltage ("No" branch), the rectifier ground 218 may be electrically disconnected form the power ground 228, at block 418. By disconnecting the rectifier ground 218 from the power ground 228, current is prevented from continuing to flow from the power ground 228 to the rectifier ground 218, and, at block 420, the bulk capacitor 220 is charged up to a predetermined level at which the downstream components can safely tolerate. The voltage of the charged capacitor is made available for the downstream components, for example, the power supply of the electricity meter 116 at block 416.

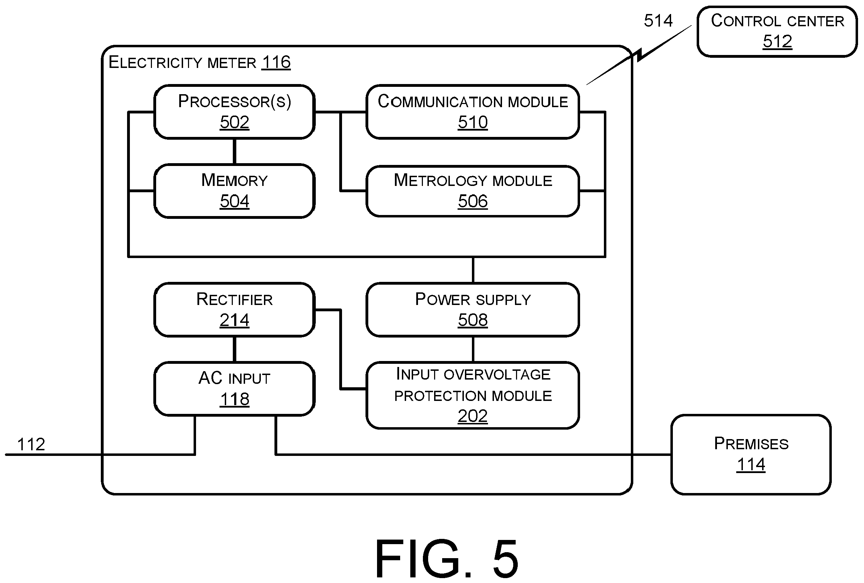

FIG. 5 illustrates an example block diagram of the electricity meter 116. The electricity meter 116 may comprise one or more processors (e.g., processors 502) communicatively coupled to memory 504. The processors 502 may include one or more central processing units (CPUs), graphics processing units (GPUs), both CPUs and GPUs, or other processing units or components known in the art. The processors 502 may execute computer-executable instructions stored in the memory 504 to perform functions or operations with one or more of components communicatively coupled to the one or more processors 502 and the memory 504 as described above with reference to FIGs. 2-4. Depending on the exact configuration of the electricity meter 116, the memory 504 may be volatile, such as RAM, non-volatile, such as ROM, flash memory, miniature hard drive, memory card, and the like, or some combination thereof. The memory 504 may store computer-executable instructions that are executable by the processors 502.

The components of the electricity meter 116 coupled to the processors 502 and the memory 504 may comprise a metrology module 506, an AC input 118, a rectifier 214 providing a high voltage DC 216 and a rectifier ground 218, an input overvoltage protection module 202 comprising a voltage monitor 204 and a ground switch 206, a power supply 508 having ground connection to a power ground 228, and a communication module 510. The metrology module 506 may be capable of measuring various metrology parameters, such as voltage, current, power consumption, and the like associated with the power line 112 and the premises 114 connected to the electricity meter 116. The communication module 510 may communicate with a control center 512 of a utility service provider and provide metrology data associated with the premises 114. In this example, the communication between the communication module 510 and the control center 512 is shown as wireless communication 514, however, the communication may also be made over a wired network, such as the Internet, a cable network, a landline telephone network, and the like.

As discussed above, with reference to FIGs. 2-4, the input overvoltage protection module 202 may monitor the voltage on the power line 112 at the AC input 118 using the voltage monitor 204 as described above with reference to FIGs. 2-4. Under normal operating conditions when there is no overvoltage or a ferroresonance condition, the ground switch 206 is biased "ON" through components that are connected to the output of the rectifier 214, a high voltage DC 216, and allows current to flow from the power ground 228 to the rectifier ground 218. As current flows from the power ground 228 to the rectifier ground 218 through the ground switch 206, the current charges or maintains the charge on the bulk capacitor 220 during operation. The voltage monitor 204 monitors the AC input voltage at the AC input 118. For example, the voltage monitor 204 may be designed to monitor the AC input voltage and limit the high voltage DC 216 to a rated voltage for the downstream components, for example, 800 Vdc relative to the power ground 228, such that the bulk capacitor 220 and all other downstream components will not experience a voltage above 800 Vdc. When the AC input voltage begins to approach a preselected threshold level, which is a level near the maximum operating range specified for the downstream components, the ground switch 206 is turned "OFF." By turning off the ground switch 206, the power ground 228 is disconnected from the rectifier ground 218, which prevents the bulk capacitor 220 from continuing to be charged and prevents excessive and damaging voltage from being provided to the downstream components. The ground switch 206 remains off until the AC input voltage at the AC input 118 falls to a safe voltage.

Some or all operations of the methods described above can be performed by execution of computer-readable instructions stored on a computer-readable storage medium, as defined below. The terms "computer-readable medium," "computer-readable instructions," and "computer executable instruction" as used in the description and claims, include routines, applications, application modules, program modules, programs, components, data structures, algorithms, and the like. Computer-readable and -executable instructions can be implemented on various system configurations, including single-processor or multiprocessor systems, minicomputers, mainframe computers, personal computers, hand-held computing devices, microprocessor-based, programmable consumer electronics, combinations thereof, and the like.

The computer-readable storage media may include volatile memory (such as random-access memory (RAM)) and/or non-volatile memory (such as read-only memory (ROM), flash memory, etc.). The computer-readable storage media may also include additional removable storage and/or non-removable storage including, but not limited to, flash memory, magnetic storage, optical storage, and/or tape storage that may provide non-volatile storage of computer-readable instructions, data structures, program modules, and the like.

A computer-readable storage medium is an example of computer-readable media. Computer-readable media includes at least two types of computer-readable media, namely computer-readable storage media and communications media. Computer-readable storage media, which may be non-transitory, includes volatile and non-volatile, removable and non-removable media implemented in any process or technology for storage of information such as computer-readable instructions, data structures, program modules, or other data. Computer-readable storage media includes, but is not limited to, phase change memory (PRAM), static random-access memory (SRAM), dynamic random-access memory (DRAM), other types of random-access memory (RAM), read-only memory (ROM), electrically erasable programmable read-only memory (EEPROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transmission medium that can be used to store information for access by a computing device. In contrast, communication media may embody computer-readable instructions, data structures, program modules, or other data in a modulated data signal, such as a carrier wave, or other transmission mechanism.

The computer-readable instructions stored on one or more non-transitory computer-readable storage media, when executed by one or more processors, may perform operations described above with reference to FIGs. 1-5. Generally, computer-readable instructions include routines, programs, objects, components, data structures, and the like that perform particular functions or implement particular abstract data types. The order in which the operations are described is not intended to be construed as a limitation, and any number of the described operations can be combined in any order and/or in parallel to implement the processes.

### CONCLUSION

Although the subject matter has been described in language specific to structural features and/or methodological acts, it is to be understood that the subject matter defined in the appended claims is not necessarily limited to the specific features or acts described. Rather, the specific features and acts are disclosed as exemplary forms of implementing the claims.

Also disclosed herein are the following numbered clauses:
1. An input overvoltage protection module comprising:
   a voltage input;
   a first ground;
   a second ground;
   a bulk capacitor coupled to the voltage input and the second ground;
   a voltage monitor coupled to the voltage input and the first ground, the voltage monitor configured to monitor an input voltage at the voltage input relative to the first ground and to output a reference voltage based at least in part on the input voltage;
   a ground switch coupled to the voltage monitor, the first ground, and the second ground, the ground switch configured to receive the reference voltage and:
      electrically connect the first ground to the second ground and charge the bulk capacitor up to a predetermined level when the reference voltage is less than or equal to a threshold voltage, and
      electrically disconnect the first ground from the second ground and prevent from charging the bulk capacitor higher than the predetermined level when the reference voltage is greater than the threshold voltage; and
      a voltage output coupled to the bulk capacitor, the voltage output configured to output an output voltage equal to a voltage across the bulk capacitor relative to the second ground.
2. The input overvoltage protection module of clause 1, wherein the voltage monitor comprises:
   a voltage divider coupled to the voltage input and the first ground, the voltage divider configured to provide the reference voltage at a first point of the voltage divider.
3. The input overvoltage protection module of clause 2, wherein the voltage divider comprises one or more Zener diodes and one or more resistors.
4. The input overvoltage protection module of any preceding clause, wherein:
   the voltage monitor comprises a switch driver coupled to the voltage monitor, the switch driver configured to:
   receive the reference voltage,
   electrically disconnect a second point of the switch driver from the first ground when the reference voltage is less than or equal to the threshold voltage, and
   electrically connect the second point to the first ground when the reference voltage is greater than the threshold voltage; and
   the ground switch is coupled to the second point, the first ground, and the second ground, and is configured to:
      electrically connect the first ground to the second ground when the second point is electrically disconnected from the first ground, and
      electrically disconnect the first ground from the second ground when the second point is electrically connected to the first ground.
5. The input overvoltage protection module of clause 4, wherein the switch driver comprises a first field effect transistor (FET) and the ground switch comprises a second FET.
6. The input overvoltage protection module of clause 5, wherein the threshold voltage is a gate-source threshold voltage of the first FET.
7. The input overvoltage protection module of clause 6, wherein:
   the reference voltage is applied to a gate of the first FET, and
   the second point is connected to a drain of the first FET and a gate of the second FET.
8. The input overvoltage protection module of clause 7, wherein:
   a source of the first FET and a source of the second FET are connected to the first ground, and
   a drain of the second FET is connected to the second ground.
9. The input overvoltage protection module of any of clauses 5 to 8, wherein the ground switch further comprises:
   a Zener diode connected to a gate of the second FET and the first ground,
   the Zener diode configured to maintain a voltage at the gate of the second FET greater than a gate-source threshold voltage of the second FET when the reference voltage is less than or equal to the threshold voltage.
10. The input overvoltage protection module of any preceding clause, wherein the bulk capacitor comprises one or more capacitors.
11. An electricity meter comprising:
   an alternating-current (AC) input configured to receive AC voltage;
   a rectifier coupled to the AC input, the rectifier configured to rectify the AC voltage and output direct-current (DC) voltage;
   a metrology module configured to monitor a plurality of metrology parameters;
   a power supply coupled to the metrology module, the power supply configured to provide power to operate the metrology module;
   an input overvoltage protection module coupled to the rectifier and the power supply, the input overvoltage protection module comprising:
      a voltage input coupled to the rectifier, the voltage input configured to receive the DC voltage;
      a first ground;
      a second ground;
      a bulk capacitor coupled to the voltage input and the first ground;
      a voltage monitor coupled to the voltage input and the first ground, the voltage monitor configured to monitor the DC voltage at the voltage input relative to the first ground and to output a reference voltage based at least in part on the DC voltage;
      a ground switch coupled to the voltage monitor, the first ground, and the second ground, the ground switch configured to receive the reference voltage and:
         electrically connect the first ground to the second ground and charge the bulk capacitor up to a predetermined level when the reference voltage is less than or equal to a threshold voltage, and
         electrically disconnect the first ground from the second ground and prevent from charging the bulk capacitor higher than the predetermined level when the reference voltage is greater than the threshold voltage; and
         a voltage output coupled to the bulk capacitor, the voltage output configured to output, to the power supply, a voltage equal to a voltage across the bulk capacitor.
12. The electricity meter of clause 11, wherein the voltage monitor comprises:
   a voltage divider coupled to the voltage input and the first ground, the voltage divider configured to provide the reference voltage at a first point of the voltage divider.
13. The electricity meter of clause 12, wherein the voltage divider comprises one or more Zener diodes and one or more resistors.
14. The electricity meter of any of clauses 11 to 13, wherein:
   the voltage monitor comprises a switch driver coupled to the voltage monitor, the switch driver configured to:
   receive the reference voltage,
   electrically disconnect a second point of the switch driver from the first ground when the reference voltage is less than or equal to the threshold voltage, and
   electrically connect the second point to the first ground when the reference voltage is greater than the threshold voltage; and
   the ground switch is coupled to the second point, the first ground, and the second ground, and is configured to:
      electrically connect the first ground to the second ground when the second point is electrically disconnected from the first ground, and
      electrically disconnect the first ground from the second ground when the second point is electrically connected to the first ground.
15. The electricity meter of clause 14, wherein the switch driver comprises a first field effect transistor (FET) and the ground switch comprises a second FET.
16. The electricity meter of clause 15, wherein the threshold voltage is a gate-source threshold voltage of the first FET.
17. The electricity meter of clause 16, wherein:
   the reference voltage is applied to a gate of the first FET,
   the second point is connected to a drain of the first FET and a gate of the second FET,
   a source of the first FET and a source of the second FET are connected to the first ground, and
   a drain of the second FET is connected to the second ground.
18. The electricity meter of any of clauses 15 to 17, wherein the switch driver further comprises:
   a Zener diode connected to a gate of the second FET and the first ground,
   the Zener diode configured to maintain a voltage at the gate of the second FET greater than a gate-source threshold voltage of the second FET when the reference voltage is less than or equal to the threshold voltage.
19. The electricity meter of any of clauses 11 to 18, wherein the bulk capacitor comprises one or more capacitors.
20. A method comprising:
   receiving an input voltage at a voltage input;
   monitoring the input voltage relative to a first ground;
   outputting a reference voltage based at least in part on the input voltage;
   when the reference voltage is less than or equal to a threshold voltage, electrically connecting the first ground to a second ground and charging a bulk capacitor up to a predetermined level, the bulk capacitor connected to the voltage input and the second ground;
   when the reference voltage is greater than the threshold voltage, electrically disconnecting the first ground from the second ground and preventing from charging the bulk capacitor higher than the predetermined level; and
   outputting an output voltage equal to a voltage across the bulk capacitor.

## Claims

1. An input overvoltage protection module comprising:
a voltage input;
a first ground;
a second ground;
a bulk capacitor coupled to the voltage input and the second ground;
a voltage monitor coupled to the voltage input and the first ground, the voltage monitor configured to monitor an input voltage at the voltage input relative to the first ground and to output a reference voltage based at least in part on the input voltage;
a ground switch coupled to the voltage monitor, the first ground, and the second ground, the ground switch configured to receive the reference voltage and:
electrically connect the first ground to the second ground and charge the bulk capacitor up to a predetermined level when the reference voltage is less than or equal to a threshold voltage, and
electrically disconnect the first ground from the second ground and prevent from charging the bulk capacitor higher than the predetermined level when the reference voltage is greater than the threshold voltage; and
a voltage output coupled to the bulk capacitor, the voltage output configured to output an output voltage equal to a voltage across the bulk capacitor relative to the second ground.

2. The input overvoltage protection module of claim 1, wherein the voltage monitor comprises:
a voltage divider coupled to the voltage input and the first ground, the voltage divider configured to provide the reference voltage at a first point of the voltage divider.

3. The input overvoltage protection module of claim 2, wherein the voltage divider comprises one or more Zener diodes and one or more resistors.

4. The input overvoltage protection module of claim 1, wherein:
the voltage monitor comprises a switch driver coupled to the voltage monitor, the switch driver configured to:
receive the reference voltage,
electrically disconnect a second point of the switch driver from the first ground when the reference voltage is less than or equal to the threshold voltage, and
electrically connect the second point to the first ground when the reference voltage is greater than the threshold voltage; and
the ground switch is coupled to the second point, the first ground, and the second ground, and is configured to:
electrically connect the first ground to the second ground when the second point is electrically disconnected from the first ground, and
electrically disconnect the first ground from the second ground when the second point is electrically connected to the first ground.

5. The input overvoltage protection module of claim 4, wherein the switch driver comprises a first field effect transistor (FET) and the ground switch comprises a second FET.

6. The input overvoltage protection module of claim 5, wherein the threshold voltage is a gate-source threshold voltage of the first FET; and optionally wherein:
the reference voltage is applied to a gate of the first FET, and
the second point is connected to a drain of the first FET and a gate of the second FET; and further optionally wherein:
a source of the first FET and a source of the second FET are connected to the first ground, and
a drain of the second FET is connected to the second ground.

7. The input overvoltage protection module of claim 5 or 6, wherein the ground switch further comprises:
a Zener diode connected to a gate of the second FET and the first ground, the Zener diode configured to maintain a voltage at the gate of the second FET greater than a gate-source threshold voltage of the second FET when the reference voltage is less than or equal to the threshold voltage.

8. An electricity meter comprising:
an alternating-current (AC) input configured to receive AC voltage;
a rectifier coupled to the AC input, the rectifier configured to rectify the AC voltage and output direct-current (DC) voltage;
a metrology module configured to monitor a plurality of metrology parameters;
a power supply coupled to the metrology module, the power supply configured to provide power to operate the metrology module;
an input overvoltage protection module of claim 1 coupled to the rectifier and the power supply, the input overvoltage protection module comprising:
a voltage input coupled to the rectifier, the voltage input configured to receive the DC voltage.

9. The electricity meter of claim 8, wherein the voltage monitor comprises:
a voltage divider coupled to the voltage input and the first ground, the voltage divider configured to provide the reference voltage at a first point of the voltage divider.

10. The electricity meter of claim 9, wherein the voltage divider comprises one or more Zener diodes and one or more resistors.

11. The electricity meter of any of claims 8 to 10, wherein:
the voltage monitor comprises a switch driver coupled to the voltage monitor, the switch driver configured to:
receive the reference voltage,
electrically disconnect a second point of the switch driver from the first ground when the reference voltage is less than or equal to the threshold voltage, and
electrically connect the second point to the first ground when the reference voltage is greater than the threshold voltage; and
the ground switch is coupled to the second point, the first ground, and the second ground, and is configured to:
electrically connect the first ground to the second ground when the second point is electrically disconnected from the first ground, and
electrically disconnect the first ground from the second ground when the second point is electrically connected to the first ground.

12. The electricity meter of claim 11, wherein the switch driver comprises a first field effect transistor (FET) and the ground switch comprises a second FET; and optionally wherein the threshold voltage is a gate-source threshold voltage of the first FET; and optionally wherein:
the reference voltage is applied to a gate of the first FET,
the second point is connected to a drain of the first FET and a gate of the second FET,
a source of the first FET and a source of the second FET are connected to the first ground, and
a drain of the second FET is connected to the second ground.

13. The electricity meter of claim 12, wherein the switch driver further comprises:
a Zener diode connected to a gate of the second FET and the first ground, the Zener diode configured to maintain a voltage at the gate of the second FET greater than a gate-source threshold voltage of the second FET when the reference voltage is less than or equal to the threshold voltage.

14. The input overvoltage protection module of any of claims 1 to 7 or the electricity meter of any of claims 8 to 13, wherein the bulk capacitor comprises one or more capacitors.

15. A method comprising:
receiving an input voltage at a voltage input;
monitoring the input voltage relative to a first ground;
outputting a reference voltage based at least in part on the input voltage;
when the reference voltage is less than or equal to a threshold voltage, electrically connecting the first ground to a second ground and charging a bulk capacitor up to a predetermined level, the bulk capacitor connected to the voltage input and the second ground;
when the reference voltage is greater than the threshold voltage, electrically disconnecting the first ground from the second ground and preventing from charging the bulk capacitor higher than the predetermined level; and
outputting an output voltage equal to a voltage across the bulk capacitor.
